# EUROPÄISCHE PATENTANMELDUNG

(11) **EP 2 264 842 A2**
(43) Veröffentlichungstag der Anmeldung: **22.12.2010**
(21) Anmeldenummer: 10006053.2
(22) Anmeldetag: 11.06.2010
(51) Int. Cl.: H01S 5/022, H01S 5/00, H01S 5/062

(54) **Laserdiodenstrahlquelle**

(30) Priorität: 12.06.2009 DE 102009025166
(71) Anmelder: Schäfter + Kirchhoff GmbH, 22525 Hamburg (DE)
(72) Erfinder: Federau, Gegor, 20255 Hamburg (DE); Oechsner, Ulrich, 22393 Hamburg (DE)
(74) Vertreter: Schildberg, Peter

(57) **Zusammenfassung**

Laserdiodenstrahlquelle, umfassend ein Vollmetallgehäuse (10) mit mindestens einem elektrischen Anschlusskabel (11), wobei in dem Vollmetallgehäuse, eine Laserelektronik (20), eine Laserdiode (30), eine im Strahlengang angeordneter Faraday-Isolator (40) und eine den Faraday-Isolator umgebende Metall-Schirmung (50) mit hoher magnetischer Permeabilität angeordnet sind, wobei die Laserdiode mit einem hochfrequent modulierten Laserstrom betrieben wird.
Über eine Fasereinkopplung (60) ist die Laserdiode (30) an eine optische Faser (65) gekoppelt. Durch diese Anordnung wird das Leistungsrauschen der Laserdiode durch optische Rückkopplung vermindert.

## Beschreibung

Die vorliegende Erfindung betrifft eine Laserdiodenstrahlquelle nach dem Anspruch 1.

Der Schwingungszustand einer Laserdiode hängt im ungestörten Betrieb vor allem von der Temperatur und dem zugeführten Laserstrom ab. Je nach Temperatur und Laserstrom schwingt die Laserdiode in einer von vielen möglichen Schwingungsmoden, die sich bezüglich optischer Leistung und Wellenlänge unterscheiden. Der Wechsel zwischen benachbarten Moden erfolgt sprunghaft. Häufige Modensprünge sind sehr wahrscheinlich, wenn sich der Arbeitspunkt der Laserdiode nahe einer Modengrenze befindet. Dieses stochastische Springen zwischen den Moden bewirkt ein starkes Leistungsrauschen, wobei durch zurück in die Laserdiode gespiegelte oder gestreute Laserstrahlung das Leistungsrauschen verstärkt wird. Es bildet sich hierbei ein instabiler externer Resonator, der einen ständigen Wechsel zwischen Schwingungsmoden hervorruft und die Laserfrequenz destabilisiert.

Für Anwendungen, bei denen eine Rückreflexion oder die Rückstreuung eines Teils der Laserstrahlung prinzipiell nicht vermeidlich ist, ist es bekannt, für einen stabilen Betrieb der Laserdiode einen Faraday-Isolator im Strahlengang anzuordnen. Dieses bekannte optische Element lässt Laserstrahlung nur in einer Richtung durch, zurückkehrende Strahlungsanteile werden blockiert.

Bei den bekannten Laserdiodenstrahlquellen ist auch bei einem aufwendigeren Messaufbau mit nachgeschaltetem Faraday-Isolator ein für viele Messungen störendes Leistungsrauschen vorhanden.

Der Erfindung liegt die Aufgabe zugrunde, eine verbesserte Laserdiodenstrahlquelle zur Verfügung zu stellen, mit der sich ein Leistungsrauschen reduzieren lässt.

Die Aufgabe wird durch eine Laserdiodenstrahlquelle mit den Merkmalen aus Anspruch 1 gelöst. Vorteilhafte Ausgestaltungen bilden den Gegenstand der Unteransprüche.

Die erfindungsgemäße Laserdiodenstrahlquelle weist ein Vollmetallgehäuse mit mindestens einem elektrischen Anschlusskabel auf, wobei in dem Vollmetallgehäuse eine Laserelektronik, eine Laserdiode, ein im Strahlengang angeordneter Faraday-Isolator und eine den Faraday-Isolator umgebende Metall-Schirmung mit hoher magnetischer Permeabilität angeordnet sind, wobei die Laserdiode mit einem hochfrequent modulierten Laserstrom betrieben wird. Die magnetische Permeabilität beträgt bevorzugt 50.000 H/m oder mehr.

Eine hochfrequente Modulation des Laserstroms bewirkt ohne Störung durch Rückreflexion oder Rückstreuung ein gemeinsames Anschwingen sehr vieler Schwingungsmoden. Für Beobachtungszeiträume, die groß gegen die Modulationsfrequenz sind, bildet sich im Mittel ein sehr stabiler Zustand mit konstanter Leistung, sehr geringem Rauschen (insb. 0,1% RMS oder weniger) und verbreitertem Wellenlängenspektrum heraus. Letzteres bewirkt eine Reduktion der Kohärenzlänge. Die Modulationsfrequenz kann z.B. 350 MHz betragen. Die Kohärenzlänge kann bei etwa 300 µm liegen. Die verringerte Kohärenzlänge hat den Vorteil, dass bei einer interferometrischen Messung wie der Fabry-Perot-Interferometrie störende Interferenzen unterdrückt werden, so dass nur die gewünschten Interferenzen zu dem Messsignal beitragen. Außerdem bewirkt die verringerte Kohärenzlänge einen geringeren Kontrast in dem Specklemuster (der Lichtgranulation), wodurch Positionsmessungen verbessert werden.

Für einen verbesserten Schutz der Laserdiode vor Rückreflexion und Rückstreuung ist der Faraday-Isolator möglichst nah an der Laserdiode angeordnet. Hierfür ist er in das Vollmetallgehäuse integriert. Möglichst frühzeitig herausgefilterte Reflexionen vermindern ein Signalrauschen, stabilisieren die Laserfrequenz und verlängern die Lebensdauer der Laserdiode. Ferner ist durch die Integration des Faraday-Isolators in das Vollmetallgehäuse ein kompakter, sichererer und einfacherer Aufbau erzielt.

Damit die Laserdiodenstrahlquelle und andere technische Geräte einander nicht wechselseitig mittels ungewollter elektrischer oder elektromagnetischer Effekte störend beeinflussen, sind die Laserelektronik und die übrigen Bauteile in einem Vollmetallgehäuse untergebracht. Hierbei ist insbesondere die Hochfrequenzmodulation zu berücksichtigen, aber auch ein Schutz der Laserelektronik vor Störfeldern von außen.

In der Umgebung des Faraday-Isolators tritt eine hohe statische Magnetfeldstärke auf. Um Störeinwirkungen zu vermeiden, ist eine Abschirmung aus Metall mit einer hohen magnetischen Permeabilität von bevorzugt mehr als 50.000 H/m vorgesehen, die das Magnetfeld dämpft. Als Metall wird bevorzugt ein µ-Metall oder allgemein eine weichmagnetische Nickel-Eisen-Legierung mit hoher magnetischer Permeabilität eingesetzt.

In einer bevorzugten Ausgestaltung ist in dem Vollmetallgehäuse im Strahlengang eine Fasereinkopplung hinter dem Faraday-Isolator vorgesehen. Da jede Fasereinkopplung Rückstreuungen erzeugt, ist es sinnvoll, den Faraday-Isolator zwischen Laserdiode und Fasereinkopplung einzufügen.

Bevorzugt ist die Fasereinkopplung ein kernzentrierter Faserstecker. Die Kernzentrierung des Faserstecker ermöglicht die Ankopplung an nachfolgende faseroptische Elemente durch einfache Steckverbinder.

Bevorzugt ist an die Fasereinkopplung ein optisches, Singlemode- oder Multimode-Faserkabel angekoppelt, wodurch sich weitere Möglichkeiten der Anwendung für die Laserdiodenstrahlquelle ergeben.

In einer bevorzugten Ausgestaltung weist das Vollmetallgehäuse mit dem mindestens einen elektrischen Anschlusskabel Durchführungskondensatoren auf, die ein Weiterleiten von Störungen über die Zuleitungen verhindern.

Im Bereich der Fasereinkopplung kann ein faseroptischer Strahlteiler zur Verminderung der Einfügedämpfung direkt angekoppelt werden.

Eine bevorzugte Ausgestaltung der erfindungsgemäßen Laserdiodenstrahlquelle wird anhand einer Figur näher erläutert.

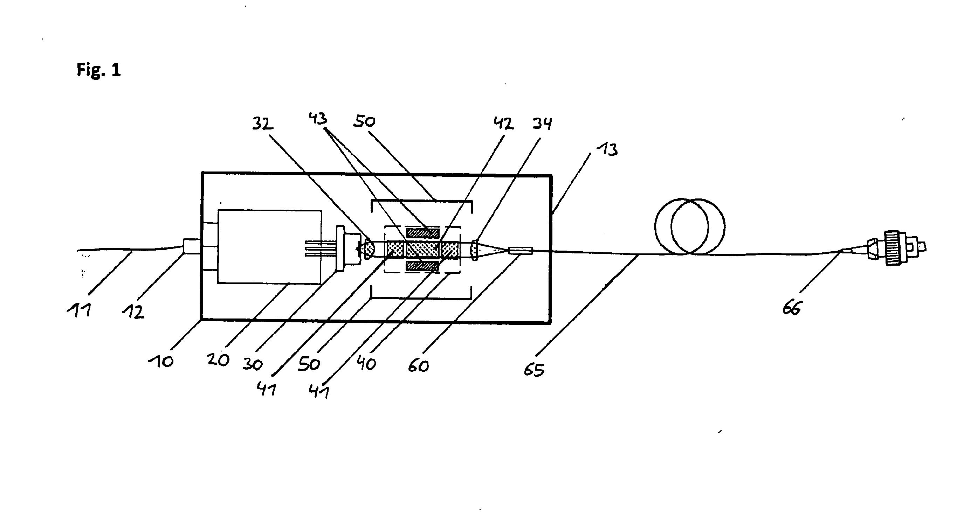

Die in Fig. 1 schematisch dargestellte Laserdiodenstrahlquelle ist in einem Ganzmetallgehäuse 10 untergebracht. Zuleitungskabel 11 für eine Laserelektronik 20 werden über einen Durchführungskondensator 12 durch eine Wandung des Vollmetallgehäuses 10 zu der Laserelektronik 20 geführt. Mit der Laserelektronik 20 ist eine Laserdiode 30 verbunden. Im Strahlengang vor der Laserdiode 30 ist eine Kollimationsoptik 32 angeordnet, die einen parallelen Strahl herstellt. Dieser Laserstrahl wird durch einen nun folgenden Faraday-Isolator 40 geleitet, der reflektierte Strahlungsanteile blockiert. Der Faraday-Isolator 40 umfasst zwei Polarisatoren 41 und einen im Stahlengang zwischen den Polarisatoren 41 angeordneten Faraday Rotator 42. Der Faraday Rotator 42 ist von einer Magnetspule 43 oder alternativ einem Dauermagneten 43 umgeben. Zur Dämpfung in der Umgebung des Faraday-Isolators 40 auftretender Magnetfelder ist der Faraday-Isolator 40 von einer µ-Metall-Schirmung 50 umgeben. Es folgt im Strahlengang eine Einkoppeloptik 34, die die einlaufende Laserstrahlung auf ein optisches Faserkabel 65 fokussiert. Das Faserkabel 65 ist lösbar mit einer Fasereinkopplung 60 verbunden, die im Bereich einer Ausgangsseite 13 des Vollmetallgehäuses 10 angeordnet ist. Das Faserkabel 65 mündet in einen Faserstecker 66.

## Patentansprüche

1. Laserdiodenstrahlquelle, umfassend ein Vollmetallgehäuse (10) mit mindestens einem elektrischen Anschlusskabel (11), wobei in dem Vollmetallgehäuse (10)
- eine Laserelektronik (20),
- eine Laserdiode (30),
- ein im Strahlengang angeordneter Faraday-Isolator (40) und
- eine den Faraday-Isolator (40) umgebende Metall-Schirmung (50) mit hoher magnetischer Permeabilität,
angeordnet sind, wobei die Laserdiode (30) mit einem hochfrequent modulierten Laserstrom betrieben wird.

2. Laserdiodenstrahlquelle nach Anspruch 1, **dadurch gekennzeichnet, dass** in dem Vollmetallgehäuse (10) im Strahlengang eine Fasereinkopplung (60) hinter dem Faraday-Isolator (40) vorgesehen ist.

3. Laserdiodenstrahlquelle nach Anspruch 2, **dadurch gekennzeichnet, dass** die Fasereinkopplung (60) ein kernzentrierter Faserstecker ist.

4. Laserdiodenstrahlquelle nach Anspruch 2 oder 3, **dadurch gekennzeichnet, dass** an die Fasereinkopplung (60) ein optisches, Singlemode- oder Multimode-Faserkabel (65) angekoppelt ist.

5. Laserdiodenstrahlquelle nach einem der Ansprüche 1 bis 4, **dadurch gekennzeichnet, dass** das Vollmetallgehäuse (10) mit dem mindestens einen elektrischen Anschlusskabel (11) Durchführungskondensatoren (12) aufweist.

6. Laserdiodenstrahlquelle nach einem der Ansprüche 1 bis 5, **dadurch gekennzeichnet, dass** ein faseroptischer Strahlteiler angekoppelt ist.

7. Laserdiodenstrahlquelle nach einem der Ansprüche 1 bis 6, **dadurch gekennzeichnet, dass** die Metall-Schirmung (50) eine magnetische Permeabilität von mindestens 50.000 H/m aufweist.
